(19) Europäisches Patentamt
European Patent Office
Office européen des brevets

(11) **EP 2 256 784 A2**

(12) **DEMANDE DE BREVET EUROPEEN**

(43) Date de publication:
**01.12.2010 Bulletin 2010/48**

(51) Int Cl.:
***H01L 21/00*** *(2006.01)*

(21) Numéro de dépôt: **10354022.5**

(22) Date de dépôt: **18.05.2010**

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**
Etats d'extension désignés:
**BA ME RS**

(30) Priorité: **27.05.2009 FR 0902560**

(71) Demandeur: **Commissariat à l'Énergie Atomique et aux Énergies Alternatives 75015 Paris (FR)**

(72) Inventeurs:
• **Mollard, Laurent 38000 Grenoble (FR)**

• **Bourgeois, Guillaume 38000 Grenoble (FR)**
• **Henry, Franck 38240 Meylan (FR)**
• **Pelliciari, Bernard 38120 Saint Egrève (FR)**

(74) Mandataire: **Dubreu, Sandrine et al Cabinet Hecké 10, rue d'Arménie Europole BP 1537 38025 Grenoble Cedex 1 (FR)**

(54) **Enceinte, dispositif et procédé de recuit d'un matériau semi-conducteur du type II-VI**

(57) L'enceinte (7) pour le recuit d'un matériau semi-conducteur du type II-VI ayant une première zone (8) de stockage d'un élément du groupe II du tableau périodique et une seconde zone (9) destinée à recevoir le matériau semi-conducteur du type II-VI. L'enceinte (7) est munie d'une cloison de séparation (12) au niveau d'une zone intermédiaire (13). Cette cloison de séparation (12) est pourvue d'un orifice de passage (14) muni d'un organe d'écoulement anti-retour des gaz (15) pour assurer le passage unidirectionnel de l'élément du groupe II du tableau périodique (5), en phase vapeur, de la première zone (8) à la seconde zone (9). Cette enceinte (7) est chauffée par des moyens de chauffage (6a, 6b), permettant de chauffer indépendamment les deux zones (8, 9).

Figure 3

EP 2 256 784 A2

**Description**

**Domaine technique de l'invention**

L'invention concerne une enceinte pour le recuit d'un matériau semi-conducteur du type II-VI ayant une première zone de stockage d'un élément du groupe II du tableau périodique et une seconde zone destinée à recevoir le matériau semi-conducteur du type II-VI.

L'invention concerne également un dispositif de recuit d'un matériau semi-conducteur du type II-VI comportant une telle enceinte et un procédé de recuit d'un matériau semi-conducteur du type II-VI en présence d'un élément du groupe II du tableau périodique utilisant un tel dispositif.

**État de la technique**

Les matériaux semi-conducteurs extrinsèques de type p ou n servent notamment à la création de jonction p-n ou ou n-p ou de double jonction n-p-n ou p-n-p de dispositifs semi-conducteurs, par exemple de diodes ou de transistors bipolaires. Ces semi-conducteurs de type p ou n sont classiquement obtenus par divers procédés de dopage. En particulier, un traitement thermique ou recuit est effectué pour diffuser un élément du groupe II du tableau périodique dans le réseau cristallin d'un matériau semi-conducteur du type II-VI afin de corriger les défauts du réseau cristallin du matériau semi-conducteur du type II-VI et notamment d'améliorer ses caractéristiques optoélectriques.

Des composés monocristallins de type n, comme des monocristaux de tellurure de cadmium et de mercure (HgCdTe, désigné ci-après par l'acronyme MCT en anglais), sont particulièrement adaptés pour une utilisation comme détecteur infrarouge intrinsèque. Ils sont obtenus en contrôlant le type de conductivité de matériaux semi-conducteurs du type II-VI par ajustement de la densité des porteurs de charge extrinsèques. Les caractéristiques de conductivité du cristal de MCT peuvent alors, classiquement, être ajustées par recuit sous pression sèche de mercure (Hg). Les atomes de mercure interstitiels agissent comme des donneurs et les lacunes en mercure comme des accepteurs. Le recuit induit le remplissage des lacunes du cristal MCT qui sont alors remplies par des atomes de mercure pour former un cristal HgCdTe de type n présentant de meilleures caractéristiques optoélectriques que le cristal de type p.

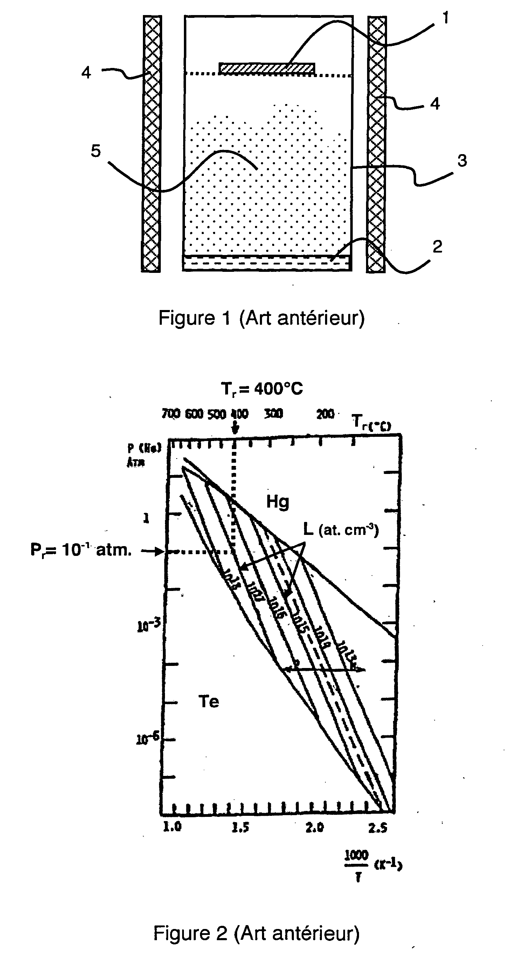

Le document JP-A-9326404 décrit le traitement thermique de tranches de MCT en présence de mercure pour améliorer les caractéristiques cristallines du MCT. Comme représenté à la figure 1, une tranche 1 de MCT et du mercure liquide 2 sont placés dans une ampoule 3 scellée. L'ampoule 3 est alors soumise à une température de recuit prédéfinie, uniforme et constante, générée par des moyens de chauffage 4, disposé autour de l'ampoule 3. Le mercure liquide 2 est disposé dans la partie inférieure de l'ampoule 3 c'est-à-dire à l'opposé de la tranche 1 de MCT. Il est vaporisé et le mercure en phase vapeur 5 est appliqué à la tranche 1 de MCT. La température de recuit est maintenue durant un temps de recuit prédéterminé jusqu'à ce que les lacunes du réseau cristallin de la tranche 1 de MCT soient remplies par le mercure en phase vapeur 5. La quantité de mercure liquide 2 introduite dans l'ampoule 3 est calculée très précisément pour correspondre à la densité de porteurs de charge souhaitée.

En effet, G.L. Destéfanis, montre dans l'article "Electrical Doping Of HgCdTe by Ion Implantation and Heat Treatment" (Journal of Crystal Growth, 1988, n° 86, P.700-722), que la densité des porteurs de charge d'un monocristal de tellurure de cadmium et de mercure dépend de la température de recuit ($T_r$) et de la pression partielle de la vapeur de mercure ($P_{Hg}$). Le diagramme d'équilibre de phases, représenté à la figure 2, définit les domaines d'équilibre d'un monocristal de tellurure de cadmium et de mercure de formule $Hg_{0,8}Cd_{0,2}Te$ lors du recuit sous pression sèche de mercure (Hg). Il met en évidence la relation entre la densité de porteurs de charge de type n ou p, la température de recuit ($T_r$) et la pression de recuit ($P_r$) correspondant à la pression partielle de la vapeur de Hg à l'équilibre dans l'ampoule 3. Le couple $T_r$ / $P_r$ conditionne, par conséquent, le dopage du monocristal $Hg_{0,8}Cd_{0,2}Te$ avec l'existence d'équilibres internes selon des lignes L à densité constante. L'ajustement des paramètres $P_r$ et $T_r$ permet donc d'obtenir un taux de dopage souhaité correspondant à une densité de porteurs de charge spécifique dans le réseau monocristallin du MCT. Toute variation de $P_r$ et/ou $T_r$ entraîne une variation du taux de dopage du monocristal $Hg_{0,8}Cd_{0,2}Te$.

La quantité de mercure liquide 2 à introduire dans l'ampoule 3 est calculée à partir de l'équation (1) des gaz parfaits suivante qui s'applique à l'équilibre :

$$P_r\, V = n_r R\, T_r \qquad\qquad (1)$$

dans laquelle:

- $P_r$ est la pression de recuit (en Pa) ;
- V est le volume de l'ampoule 3 occupé par le mercure en phase vapeur 5 (en $m^3$);

- $n_r$ est le nombre de moles de mercure liquide 2 introduit dans l'ampoule 3 (en mole) ;
- R est la constante universelle des gaz parfaits R= 8,314 472 J.K$^{-1}$.mol$^{-1}$:
- $T_r$ est la température de recuit (en K).

Le nombre de moles $n_r$ de mercure liquide 2 introduit dans l'ampoule 3 nécessaire pour remplir les lacunes du monocristal $Hg_{0,8}Cd_{0,2}Te$ et obtenir une densité de porteurs de charge donnée répond à l'équation (2) suivante :

$$n_r = (P_r \, V \,)/(R \, T_r) \qquad (2)$$

Connaissant la masse molaire p du mercure (200,59 g.mol$^{-1}$), on en déduit la masse de mercure liquide 2 à introduire dans l'ampoule 3 à partir de l'équation (3) suivante :

$$m = \rho \times (P_r \, V \,)/(R \, T_r) \qquad (3)$$

À titre d'exemple, pour obtenir un monocristal $Hg_{0,8}Cd_{0,2}Te$ avec une densité de porteurs de charge de $10^{17}$ at.CM$^{-3}$, au cours d'un recuit étant réalisé à une température de recuit $T_r$ de 400°C (673,15 K), la pression $P_r$ sera de $10^{-1}$ atm ($1,01325.10^4$ Pa ) selon le diagramme d'équilibre de phases de la figure 2.

À partir de l'équation (1), on calcule alors le nombre de moles de mercure correspondant au couple ($P_r$, $T_r$) à l'équilibre thermodynamique, soit $n_r = 1,44.10^{-3}$ mole pour une pression de recuit $P_r = 1,01325.10^4$ Pa ($10^{-1}$ atm) et une température $T_r = 673,15$ K (400°C).

Connaissant la masse molaire du mercure (200,59 g.mol$^{-1}$) et pour un volume d'ampoule 3 correspondant à $8.10^{-4}$ m$^3$, on en déduit la quantité de mercure liquide 2 nécessaire pour une densité de porteurs de charge de $10^{17}$ at.cm$^{-3}$ soit 289 mg de Hg.

La quantité de mercure liquide 2 à introduire dans l'ampoule 3 est alors pesée exactement avant d'être introduit dans l'ampoule 3. L'ampoule 3 est ensuite scellée.

Néanmoins, la pesée du mercure liquide 2 est souvent sujette à des erreurs avec des incertitudes qui s'élèvent en masse généralement à quelques pourcents en masse. Ces incertitudes font varier la pression de recuit $P_r$ de façon significative et, par voie de conséquence, le taux de dopage. Le dopage à partir d'un tel dispositif est peu reproductible et manque de précision. De plus, la différence de pression entre la pression réelle obtenue dans l'ampoule 3 et la pression théorique n'est constatée qu'une fois l'équilibre thermodynamique atteint. Cette erreur ne peut alors être corrigée qu'en cassant l'ampoule 3 et en réitérant l'opération de pesée, scellement de l'ampoule 3 et recuit pour obtenir la pression de recuit $P_r$ souhaitée.

De plus, la pesée du mercure liquide 2 avant chargement dans l'ampoule 3 est souvent la source de contamination. La pesée précise du mercure liquide 2 nécessite plusieurs manipulations, classiquement, avec une seringue et une spatule, pour ajuster la pesée. Ces manipulations successives peuvent induire un contre-dopage ou un dopage non voulu de la tranche 1 de MCT.

D'autres procédés connus proposent un recuit en présence d'un excès de mercure. Le document US-A-3723190 décrit, notamment, un procédé pour la préparation de MCT de formule $Hg_{1-x}Cd_xTe$ (avec $0 < x < 1$) de type n à partir d'un matériau $Hg_{1-x}Cd_xTe$ de type p soumis à un gradient de température. Le traitement thermique comporte un premier traitement à une température inférieure à la température du solidus du MCT pour obtenir un matériau homogène puis un second traitement en présence d'un excès de mercure afin d'ajuster la stoechiométrie du matériau et, par conséquent, le type de conductivité. Le second traitement thermique réduit la concentration en électron libre dans le matériau de type n ou convertit le matériau de type p en type n. Néanmoins, l'excès de mercure présent tout au long du second traitement thermique fixe une partie des éléments constitutifs de la tranche de MCT et entraîne la dissolution ou la précipitation de ces éléments via la phase gazeuse de mercure. Cet effet secondaire affecte la qualité du dopage.

**Objet de l'invention**

L'invention a pour but une enceinte pour le recuit d'un matériau semi-conducteur du type II-VI remédiant aux inconvénients de l'art antérieur. En particulier, l'invention a pour but de proposer une enceinte permettant le dopage de matériau semi-conducteur de type II-VI de façon précise, reproductible et fiable, tout en diminuant les risques de contamination.

L'invention a également pour but un dispositif de recuit d'un matériau semi-conducteur du type II-VI comprenant cette enceinte ainsi qu'un procédé de recuit en présence d'un élément du groupe II du tableau périodique utilisant un tel dispositif.

Selon l'invention, ce but est atteint par une enceinte, un dispositif de recuit et un procédé de recuit selon les revendications annexées.

**Description sommaire des dessins**

D'autres avantages et caractéristiques ressortiront plus clairement de la description qui va suivre des modes particuliers de réalisation de l'invention donnés à titre d'exemples non limitatifs et représentés aux dessins annexés, dans lesquels:

- La figure 1 représente, schématiquement et en coupe, un dispositif de recuit de matériaux semi-conducteurs du type II-VI selon l'art antérieur.
- La figure 2 représente un diagramme d'équilibre de phases en fonction de la pression partielle de mercure et de la température de recuit d'un tellurure de cadmium et de mercure de formule $Hg_{0,77}Cd_{0,23}Te$.
- La figure 3 représente, schématiquement et en coupe, un mode particulier de réalisation d'un dispositif de recuit d'un matériau semi-conducteur du type II-VI selon l'invention.
- Les figures 4 à 8 représentent, schématiquement et en coupe, les différentes étapes d'un procédé de recuit d'un matériau semi-conducteur du type II-VI en présence d'un élément du groupe II du tableau périodique utilisant le dispositif de recuit selon la figure 3.
- La figure 9 représente le diagramme de phase liquide/vapeur du mercure.
- La figure 10 représente l'évolution du nombre de moles de mercure en phase vapeur en fonction de la température, à l'équilibre thermodynamique dans une enceinte ayant un volume $V_2 = 8.10^{-4}$ $m^3$.

**Description des modes de réalisation particuliers de l'invention**

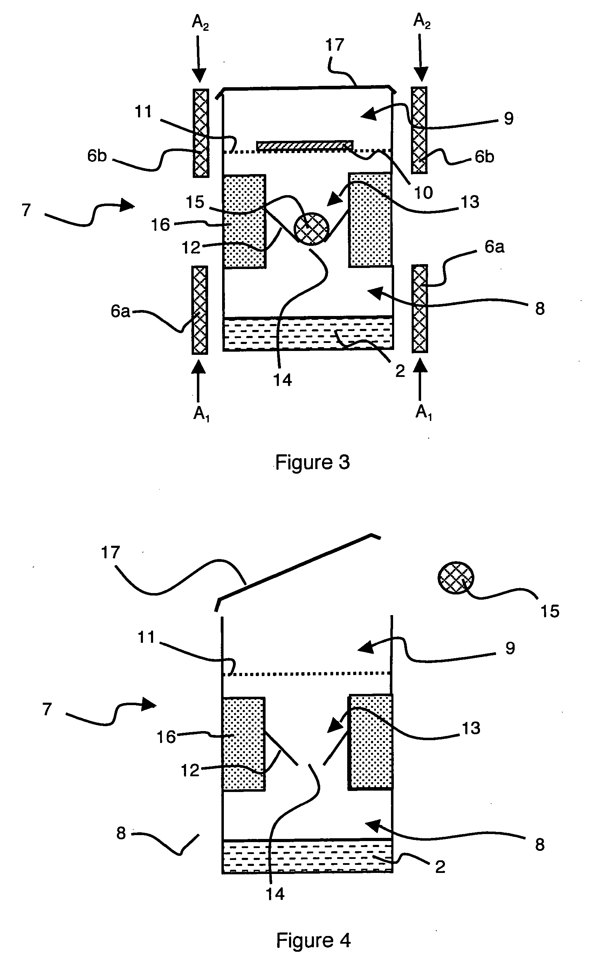

Comme illustré à la figure 3, le dispositif de recuit d'un matériau semi-conducteur du type II-VI en présence d'un élément du groupe II du tableau périodique comporte une enceinte 7 pour le recuit du matériau semi-conducteur du type II-VI, des moyens de chauffage 6a et 6b et des moyens de contrôle de la température de chauffage. L'enceinte 7 est particulièrement adaptée pour le recuit de tellurure de cadmium et de mercure (HgCdTe) comme matériau semi-conducteur du type II-VI.

Le tellurure de cadmium et de mercure est un composé de formule générale $Hg_{1-x}Cd_xTe$ où x est strictement compris entre 0 et 1 (0 < x < 1).

L'élément du groupe II du tableau périodique est, avantageusement, le mercure. Le mercure présente l'avantage d'avoir une pression partielle de vapeur très faible par rapport aux autres éléments du groupe II du tableau périodique.

D'autres semi-conducteurs tels que CdTe, GaAs, GaP ou InP ayant un dopage ajustable par recuit sous pression de vapeur d'un de leur élément peuvent également être utilisés.

Selon un mode de réalisation particulier, le matériau semi-conducteur du type II-VI est du tellurure de cadmium et de mercure et l'élément du groupe II du tableau périodique est du mercure liquide 2 à température ambiante.

Comme représenté à la figure 3, l'enceinte 7 a une première zone 8 de stockage du mercure liquide 2 et une seconde zone 9 destinée à recevoir le MCT. Ce dernier se présente classiquement sous la forme d'une tranche 10 de MCT. Une grille 11 fixée aux parois internes de l'enceinte 7 permet de supporter la tranche 10 de MCT, tout en exposant le maximum de surface du MCT.

L'enceinte 7 comporte, par ailleurs, une cloison de séparation 12 au niveau d'une zone intermédiaire 13. La cloison de séparation 12 est pourvue d'un orifice de passage 14 muni d'un organe 15 d'écoulement anti-retour des gaz pour assurer le passage unidirectionnel du mercure en phase vapeur 5, de la première zone 8 à la seconde zone 9. La cloison de séparation 12 délimite les volumes $V_1$ et $V_2$, correspondant respectivement à la première zone 8 et à la seconde zone 9.

L'organe 15 d'écoulement anti-retour des gaz peut être constitué par un clapet anti-retour, de préférence, un clapet anti-retour à bille (figure 3).

Selon une variante, l'organe 15 d'écoulement anti-retour des gaz peut être constitué par un système mécanique dont l'ouverture et/ou la fermeture est déclenchée manuellement.

L'enceinte 7 a, avantageusement, une section interne, réduite au niveau de la zone intermédiaire 13. L'enceinte 7 est, de préférence, en quartz, par exemple une ampoule de quartz, présentant un étranglement au niveau de la zone intermédiaire 13. Cette caractéristique structurelle permet de réduire les échanges thermiques entre les première et seconde zones, respectivement 8 et 9. La paroi de l'enceinte 7 comporte, de préférence, une isolation thermique 16 au niveau de la zone intermédiaire 13. Ainsi, les première et seconde zones 8 et 9, sont isolées thermiquement l'une de l'autre. Toute la circonférence de l'enceinte 7 peut, par exemple, être entourée au niveau de la zone intermédiaire 13 par de la laine de roche constituant l'isolation thermique 16.

L'enceinte 7 comporte, avantageusement, un élément d'obturation et de scellement 17 (à la partie supérieure sur la figure 3) qui assure la fermeture hermétique de l'enceinte 7. Ainsi, l'enceinte 7 peut être soumise à une pression réduite, après chargement du mercure liquide 2 dans la première zone 8 par mise sous vide de l'enceinte 7, avant obturation de l'enceinte 7 par scellement de l'élément d'obturation et de scellement 18.

Ainsi, le volume $V_2$ de la seconde zone 9 est délimité à sa partie supérieure par l'élément d'obturation et de scellement 17, par les parois latérales de l'enceinte 7 et à sa partie inférieure, par la cloison de séparation 12 et le clapet anti-retour à bille 15.

Le dispositif de recuit d'une tranche 10 de MCT en présence de mercure liquide 2 comporte l'enceinte 7, les moyens de chauffage 6a et 6b, et des moyens de contrôle, non représentés, permettant de contrôler la température de chauffage de la première zone 8 et de la seconde zone 9, indépendamment l'une de l'autre.

Plusieurs tranches 10 de MCT peuvent être placées dans la seconde zone 9 les unes à côté des autres ou les unes au-dessus des autres sur des grilles 11 espacés les unes des autres.

Les moyens de chauffage (6a et 6b sur la figure 3) permettent de chauffer indépendamment la première et la seconde zone, respectivement 8 et 9, et de les maintenir à des températures identiques ou différentes.

À titre d'exemple, des signaux de contrôle $A_1$ contrôlent les moyens de chauffage 6a de la première zone 8, tandis que des signaux de contrôle $A_2$ contrôlent indépendamment les moyens de chauffage 6b de la seconde zone 9.

Selon un mode de réalisation particulier représenté à la figure 3, les moyens de chauffage 6a et 6b peuvent être constitués par au moins deux moyens de chauffage couvrant respectivement la première et la seconde zone 8 et 9. Chaque moyen de chauffage entoure, avantageusement, toute la circonférence de l'enceinte 7 autour de la zone correspondante, afin d'obtenir une température homogène. Les moyens de chauffage sont disposés de manière à ce qu'une température constante et uniforme puisse être obtenue dans chacune des zones 8 et 9 et dans la zone intermédiaire 13. La présence de point froid doit être évitée pour empêcher toute condensation au sein de l'enceinte 7.

La régulation de la température des moyens de chauffage, par les moyens de contrôle, permet également de maîtriser les gradients de température dans l'enceinte 7 en chauffant simultanément et/ou de façon consécutive la première zone 8 et seconde zone 9.

De plus, l'isolation thermique 16 minimisant les échanges thermiques entre la première zone 8 et la seconde zone 9, améliore le contrôle du chauffage et/ou le refroidissement des première et seconde zones, respectivement 8 et 9.

Dans un mode de réalisation préférentiel, les moyens de chauffage 6a et 6b et les moyens de contrôle de la température de chauffage de la première zone 8 et de la seconde zone 9, indépendamment l'une de l'autre, sont avantageusement constitués par un four bizone.

Le dopage d'un matériau semi-conducteur du type II-VI 10 en présence d'un élément du groupe II du tableau périodique 2 est réalisé selon un procédé de recuit utilisant le dispositif de recuit décrit ci-dessus.

Selon un mode de réalisation particulier représenté aux figures 4 à 8, le procédé comporte une première étape de chargement de mercure liquide 2 à température ambiante dans la première zone 8 du dispositif de recuit. Pendant cette étape, l'élément d'obturation et de scellement 17 est désolidarisé de l'enceinte 7 afin de permettre l'accès à la première zone 8.

Afin d'éviter les problèmes de contamination et s'affranchir de toute pesée de mercure liquide 2 constituant l'élément dopant, un excès de mercure liquide 2 est utilisé pour alimenter l'enceinte 7 en élément dopant. L'excès tient compte de la quantité de mercure 2 calculée à partir de l'équation (3) ci-dessus, quantité nécessaire pour l'obtention d'un taux de dopage déterminé d'une tranche 10 de MCT. Le taux de dopage correspond à un nombre de moles $n_r$ de mercure en phase vapeur 5 dans un volume $V_2$ défini de la seconde zone 9. Ainsi, pour un volume $V_2$ de $8.10^{-4}$ m$^3$, un nombre de moles $n_r$ égal à $1,44.10^{-3}$ mole, et un couple $(T_r, P_r)$ correspondant respectivement à 400°C et $10^{-1}$ atm, la quantité de mercure liquide 2 nécessaire pour l'obtention d'un taux de dopage de $10^{17}$ at.cm$^{-3}$ est de 289 mg de mercure. Pratiquement, des ampoules de conditionnement de mercure liquide 2, prédosées, vendues dans le commerce, peuvent être utilisées. Les ampoules de conditionnement sont alors choisies pour permettre l'introduction dans la première zone 8 de l'ampoule 7 d'une quantité de mercure liquide 2 en excès, c'est-à-dire supérieure à 300 mg, de préférence largement supérieure à cette valeur. À titre d'exemple, on peut introduire 500mg à 5000mg mercure liquide 2. Le mercure liquide 2 est, avantageusement, transféré de son ampoule de conditionnement initiale à la première zone 8 de l'enceinte 7. Ce transfert est réalisé sans manipulation ou quelconque contact avec des objets pouvant être la source d'une contamination du mercure liquide 2.

Lorsque l'organe 15 d'écoulement anti-retour des gaz est un clapet anti-retour à bille, le chargement du mercure liquide 2 est effectué une fois le clapet anti-retour à bille 15 sorti de son logement pour libérer l'orifice de passage 14 (figure 4).

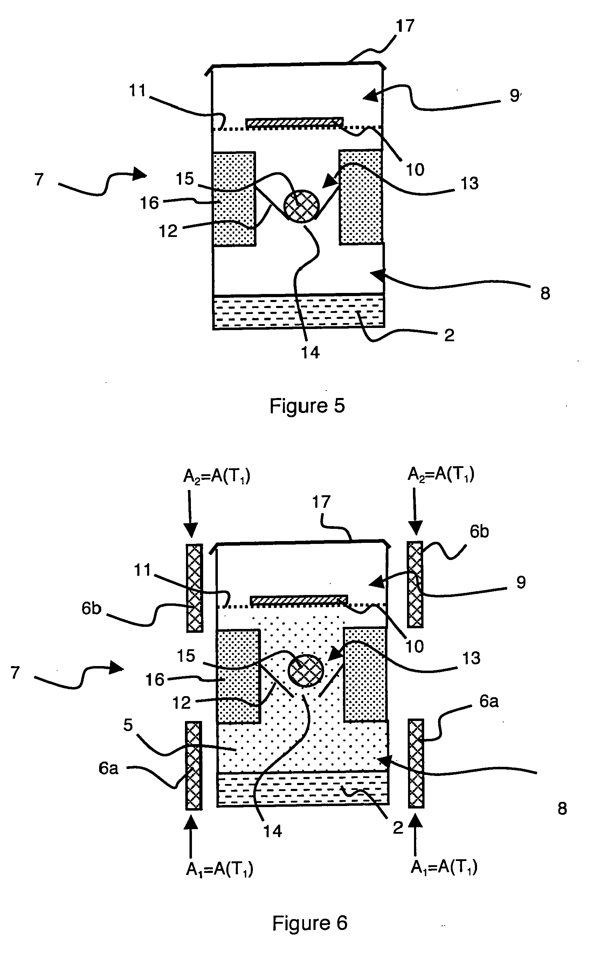

Comme représenté à la figure 5, le clapet anti-retour à bille 15 est ensuite replacé dans son logement afin d'obturer l'orifice de passage 14. La tranche 10 de MCT est disposée sur la grille 11 et l'enceinte 7 est mise sous-vide, de façon à appliquer une pression proche de zéro dans l'enceinte 7. La mise sous vide est réalisée selon tout procédé connu. Par exemple, l'enceinte 7 peut être placée dans une chambre à vide non représentée.

Selon une variante non représentée, préalablement à la mise sous vide, l'enceinte 7 est refroidie avec de l'azote liquide afin de figer le mercure pendant l'étape de pompage.

L'élément d'obturation et/ou de scellement 17 est ensuite repositionné de façon à rendre l'enceinte 7 hermétique, par exemple par scellement.

Les moyens de chauffage sont contrôlés de façon manuelle ou par programmation automatique par les moyens de contrôle de la température de chauffage de la première zone 8 et de la seconde zone 9, indépendamment l'une dé l'autre.

La première zone 8 et la seconde zone 9, sont alors chauffées à une même température $T_1$ prédéterminée, soit simultanément soit successivement, pour provoquer le passage du mercure en phase vapeur 5 de la première zone 8 à la seconde zone 9 (figure 6). Ceci peut être obtenu par application aux moyens de chauffage 6a et 6b, de signaux $A_1=A_2=A(T_1)$ identiques si les volumes $V_1$ et $V_2$ sont égaux.

La température $T_1$ est calculée pour obtenir un nombre de moles de mercure $n_r$ déterminé dans la seconde zone 9. Ce nombre de moles $n_r$ se réfère au taux de dopage avec le mercure en phase vapeur 5 d'une tranche 10 de MCT ayant une stoechiométrie connue, à un volume donné. Le nombre de moles $n_r$ correspond à une densité de porteurs de charge souhaitée pour le couple $(T_r, P_r)$ déterminé selon le diagramme représenté à la figure 2. À titre d'exemple, on sélectionne le couple $(T_r, P_r) = (400°C, 10^{-1}$ atm) pour une densité de porteurs de charge de $10^{17}$ at.cm$^{-3}$.

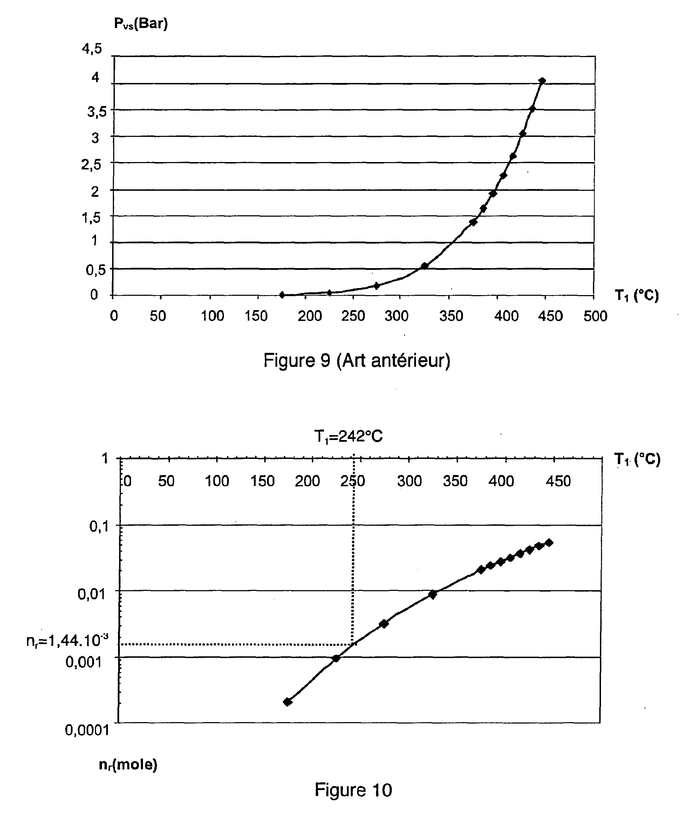

La température $T_1$ est déterminée à partir du diagramme connu de changement de phase liquide/vapeur du mercure représenté à la figure 9 (loi de Clapeyron). À l'équilibre thermodynamique, le mercure en phase vapeur 5 est en équilibre avec le mercure liquide 2 et la pression partielle de vapeur $P_v$ du mercure correspond à la pression de vapeur saturante $P_{vs}$ du mercure.

Par application de l'équation (2), pour un volume $V_2$ donné, par exemple $8.10^{-4}$ m$^3$ et à partir du diagramme de phase connu représenté à la figure 9, on peut tracer la courbe d'évolution du nombre de moles de mercure présent dans la vapeur, à l'équilibre thermodynamique, en fonction de la température (figure 10). Le nombre de moles $n_r$ de mercure en phase vapeur 5 présent dans la seconde zone 9 est donc entièrement contrôlé par la température $T_1$.

À titre d'exemple, pour le couple $(T_r, P_r)$ correspondant respectivement à 400°C et $10^{-1}$ atm (figure 2), le nombre de moles $n_r$ calculé selon l'équation (2) et pour le volume défini précédemment est de $1,44.10^{-3}$ mole.

En reportant cette valeur $n_r$ sur la courbe du diagramme de la figure 10, on détermine une température $T_1$ de 242°C. Cette température de 242°C correspond à la température à laquelle doit être soumise l'enceinte 7 et, plus particulièrement la première zone 8 et la seconde zone 9, pour que la pression partielle de vapeur de mercure $P_v$, à l'équilibre thermodynamique, soit égale à la pression de vapeur saturante $P_{vs}$. À une température $T_1$ égale à 242°C, le nombre de moles $n_r$ de mercure en phase vapeur 5 est égal à $1,44.10^{-3}$ mole pour un volume $V_2$ de la seconde zone 9 de $8.10^{-4}$ m$^3$.

Comme représenté à la figure 6, le mercure en phase vapeur 5 émis dans la première zone 8 soulève le clapet anti-retour à bille 15 et pénètre dans la seconde zone 9. Le chauffage de la première et de la seconde zone à la même température $T_1$ provoque le passage du mercure en phase vapeur 5 de la première zone 8 à la seconde zone 9 jusqu'à ce que la pression partielle de la vapeur $P_v$ du mercure dans la totalité de l'enceinte 7 atteigne une valeur correspondant à la pression de vapeur saturante $P_{vs}$ du mercure pour un taux de dopage souhaité. La température est, avantageusement, homogène afin d'éviter la présence de points froids, en particulier, dans la zone intermédiaire 13.

Les moyens de chauffage étant un four, l'enceinte 7 peut, éventuellement, être déplacée dans le four, au cours du chauffage, pour éviter la formation de points froids localisés dans l'enceinte 7, entraînant la condensation du mercure.

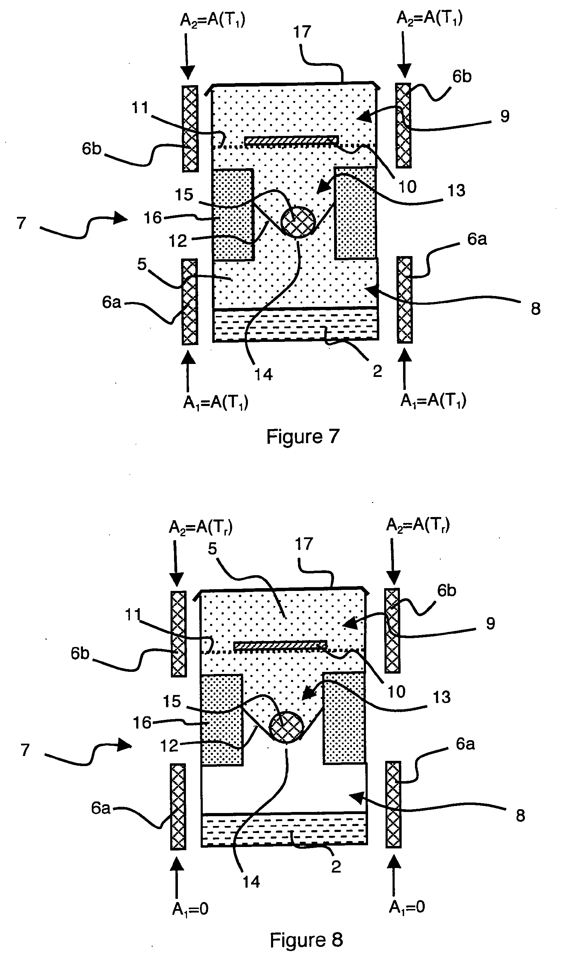

Comme représenté à la figure 7, à l'équilibre thermodynamique, le mercure en phase vapeur 5 est en équilibre avec le mercure liquide 2 en excès et emplit la totalité de l'enceinte 7. La pression dans l'enceinte 7 est alors égale à la pression de vapeur saturante $P_{vs}$ du mercure. La pression est homogène dans les première et seconde zones, respectivement 8 et 9. Le clapet anti-retour à bille 15 retombe, par conséquent, dans son logement obturant l'orifice de passage 14.

La tranche 10 de MCT est ensuite soumise à un recuit en chauffant au moins la seconde zone 9 à la température de recuit $T_r$, supérieure à $T_1$. La température de recuit $T_r$ définit la pression de recuit $P_r$ dans un volume donné (figure 2). Le mercure en phase vapeur 5 présente dans la seconde zone 9 contient un nombre de moles de mercure $n_r$ calculé selon l'équation (3) correspondant au couple $(T_r, P_r)$.

Le chauffage de la première zone 8 est interrompu pendant l'étape de recuit. Avantageusement, pendant l'étape de recuit, la première zone 8 est refroidie à une température inférieure à $T_1$ de façon à améliorer l'étanchéité du clapet anti-retour à bille 15. Lors de cette étape, la zone intermédiaire 13 est, de préférence, à la température $T_1$ pour éviter la formation de points froids dans le volume $V_2$.

Le chauffage à la température de recuit $T_r$, correspondant au niveau de dopage désiré est, avantageusement, appliqué uniquement à la seconde zone 9. Ceci peut être obtenu par des signaux $A_2=A(T_r)$ et $A_1=0$. Comme représenté à la figure 8, la pression $P_r$ dans la seconde zone 9 est alors plus élevée que celle de la première zone 8 qui se refroidit, provoquant la condensation du mercure en phase vapeur 5 de la zone 8. Le clapet anti-retour à bille 15 fermé, empêche le retour du mercure en phase vapeur 5 de la seconde zone 9 à la première zone 8.

La température de recuit $T_r$ est maintenue durant un temps de recuit classiquement de l'ordre de plusieurs jours nécessaire pour atteindre le taux de dopage souhaité.

Selon un mode de réalisation particulier non représenté, des capteurs de pression sont disposés à l'intérieur de l'enceinte 7, répartis de façon à pouvoir mesurer la pression dans la première zone 8 et dans la seconde zone 9 pour vérifier que la pression de recuit $P_r$ est bien la pression désirée. Ainsi, le procédé de recuit d'un matériau semi-conducteur du type II-VI 10 en présence d'un élément du groupe II du tableau périodique 2 comporte les étapes successives suivantes :

- le chargement d'un excès de l'élément du groupe II du tableau périodique 2 dans la première zone 8,
- la mise sous vide de l'enceinte 7,
- le chauffage de la première et de la seconde zone, respectivement 8 et 9 à une même température $T_1$ prédéterminée, jusqu'à obtenir l'équilibre de la pression entre les première et seconde zones, respectivement 8 et 9, à la pression de vapeur saturante $P_{vs}$ du mercure,
- le recuit du matériau semi-conducteur du type II-VI 10 en chauffant la seconde zone 9 à une température de recuit $T_r$, supérieure à $T_1$.

À titre d'exemple, une ampoule en quartz 7 de 10 cm de diamètre présente une première zone 8 de 10 cm de hauteur et une seconde zone 9 de 10 cm de hauteur munie d'une grille 11 sur laquelle est positionnée une tranche de $Hg_{0,8}Cd_{0,2}Te$ de 10 $\mu$m d'épaisseur pour une surface de 36mm x 38mm. L'ampoule 7 est remplie avec 5 g de mercure liquide 2 directement transféré à partir d'une ampoule de conditionnement. La zone intermédiaire 13 a une section interne, réduite de 1,5 cm et sur 5 cm de hauteur. La cloison de séparation 12 en quartz soutient le clapet anti-retour à bille 15 en quartz, de 1 cm de diamètre. L'ampoule 7 est refroidie avec de l'azote liquide et mise sous vide jusqu'à atteindre une pression de 0,1 Pa. L'ampoule 7 est fermée hermétiquement en scellant un bouchon en quartz 18 avec un chalumeau. L'ampoule 7 est ensuite placée dans un four bizone à lampe halogène commercialisé par la société AET technologies, puis chauffée selon un gradient de température programmé. La première zone 8 et la seconde zone 9 sont d'abord chauffées à une température $T_1$ de 241,3°C jusqu'à l'équilibre thermodynamique. Puis la seconde zone 9 est chauffée à une température de recuit $T_r$ de 400°C durant 1 jour. Le chauffage de la première zone 8 est interrompu pendant l'étape de recuit. La densité des porteurs de charge obtenue est de $10^{17}$ at.cm$^{-3}$.

L'ajustement de la température de la seconde zone 9 permet de modifier la pression de recuit $P_r$ sans avoir besoin d'interrompre le traitement thermique et d'ouvrir l'enceinte 7. Une variation des températures $T_1$ et/ou $T_r$ entraîne une modification de $n_r$ et/ou de la pression $P_r$ et donc du taux de dopage. Grâce à ce dispositif de recuit, le dopage de matériaux semi-conducteur du type II-VI peut ainsi être réalisé uniquement à partir du contrôle et de l'ajustement de la température.

Or, la température peut être facilement maîtrisée et régulée au cours du recuit, par exemple par thermocouple. Par ailleurs, l'incertitude sur la mesure de la température est bien inférieure à celle sur la pesée du mercure liquide 2. En effet, l'incertitude sur le nombre de moles $n_r$ est calculée à partir de l'équation (4) suivante :

$$\Delta n = n \times (\Delta T / T) \qquad (4)$$

Par exemple, pour un nombre de moles de 1,44.10-3 mole et une température de recuit de 673,15 K avec une marge erreur de < 1 K, la marge d'erreur sur le nombre de moles $\Delta n$ s'élève à $10^{-5}$ mole soit 0,14% contre quelque pourcents dans le cas de la pesée. Le gain est donc supérieur à un facteur 10.

Le dispositif de recuit décrit ci-dessus est efficace et permet de s'affranchir de manipulations pouvant affecter la qualité des matériaux semi-conducteurs du type II-VI dopés lors du traitement thermique. Par ailleurs, contrairement aux procédés de fabrication de l'art antérieur, le procédé de recuit selon l'invention, basé sur le contrôle et l'ajustement des températures $T_1$ et $T_r$ est facile à mettre en oeuvre, souple et garantit le contrôle du taux de dopage avec une excellente reproductibilité et un taux de contamination très faible.

## Revendications

1. Enceinte pour le recuit d'un matériau semi-conducteur du type II-VI ayant une première zone (8) de stockage d'un élément du groupe II du tableau périodique et une seconde zone (9) destinée à recevoir le matériau semi-conducteur du type II-VI, **caractérisée en ce qu'**elle comporte une cloison de séparation (12) au niveau d'une zone intermédiaire (13), ladite cloison de séparation (12) étant pourvue d'un orifice de passage (14) muni d'un organe (15) d'écoulement anti-retour des gaz pour assurer le passage unidirectionnel de l'élément du groupe II du tableau périodique, en phase vapeur (5), de la première zone (8) à la seconde zone (9).

**2.** Enceinte selon la revendication 1, **caractérisée en ce que** l'organe (15) d'écoulement anti-retour des gaz est constitué par un clapet anti-retour.

**3.** Enceinte selon la revendication 2, **caractérisée en ce que** le clapet anti-retour est un clapet anti-retour à bille.

**4.** Enceinte selon l'une quelconque des revendications 1 à 3, **caractérisée en ce que** l'enceinte (7) a une section interne, réduite au niveau de la zone intermédiaire (13).

**5.** Enceinte selon l'une quelconque des revendications 1 à 4, **caractérisée en ce que** la paroi de l'enceinte (7) comporte une isolation thermique (16) au niveau de la zone intermédiaire (13).

**6.** Enceinte selon l'une quelconque des revendications 1 et 5, **caractérisée en ce que** l'enceinte (7) est en quartz.

**7.** Enceinte selon l'une quelconque des revendications 1 et 6, **caractérisée en ce que** l'enceinte (7) comporte un élément d'obturation et de scellement (17).

**8.** Enceinte selon l'une quelconque des revendications 1 à 7, **caractérisée en ce que** le matériau semi-conducteur du type II-VI est du tellurure de cadmium et de mercure, de formule générale $Hg_{1-x}Cd_xTe$ où x est compris entre 0 et 1.

**9.** Enceinte selon l'une quelconque des revendications 1 à 8, **caractérisée en ce que** l'élément du groupe II du tableau périodique est le mercure.

**10.** Dispositif de recuit d'un matériau semi-conducteur du type II-VI en présence d'un élément du groupe II du tableau périodique, **caractérisé en ce qu'**il comporte une enceinte (7) selon l'une quelconque des revendications 1 à 9, des moyens de chauffage (6a, 6b) et des moyens de contrôle permettant de contrôler la température de chauffage de la première zone (8) et de la seconde zone (9), indépendamment l'une de l'autre.

**11.** Dispositif selon la revendication 10, **caractérisé en ce que** les moyens de chauffage (6a, 6b) et les moyens de contrôle de la température de chauffage de la première zone (8) et de la seconde zone (9), indépendamment l'une de l'autre, sont constitués par un four bizone.

**12.** Procédé de recuit d'un matériau semi-conducteur du type II-VI (10) en présence d'un élément du groupe II du tableau périodique (2) utilisant un dispositif de recuit selon l'une des revendications 10 et 11, **caractérisé en ce qu'**il comporte les étapes successives suivantes:

- chargement d'un excès de l'élément du groupe II du tableau périodique (2) dans la première zone (8) dudit dispositif de recuit, ledit excès étant calculé par rapport à la quantité d'élément du groupe II du tableau périodique (2) nécessaire pour l'obtention d'un taux de dopage du matériau semi-conducteur du type II-VI déterminé,
- mise sous vide de l'enceinte (7) dudit dispositif,
- obturation de l'enceinte (7),
- chauffage de la première et de la seconde zone (8, 9) à une température $T_1$ prédéterminée pour provoquer le passage de l'élément du groupe II en phase vapeur (5) de la première zone (8) à la seconde zone (9), jusqu'à ce que la pression partielle de la vapeur $P_v$ de l'élément du groupe II dans l'enceinte (7) atteigne une valeur correspondant à la pression de vapeur saturante $P_{vs}$ dudit élément du groupe II pour un taux de dopage souhaité,
- recuit du matériau semi-conducteur du type II-VI (10) en chauffant la seconde zone (9) à une température de recuit $T_r$, supérieure à $T_1$.

**13.** Procédé selon la revendication 12, **caractérisé en ce que** le chauffage de la première zone (8) est interrompu pendant l'étape de recuit.

**14.** Procédé selon l'une des revendications 12 et 13, **caractérisé en ce que** pendant l'étape de recuit, la première zone (8) est refroidie à une température inférieure à la température $T_1$.

Figure 1 (Art antérieur)

Figure 2 (Art antérieur)

Figure 3

Figure 4

Figure 5

$A_2=A(T_1)$      $A_2=A(T_1)$

$A_1=A(T_1)$      $A_1=A(T_1)$

Figure 6

Figure 7

Figure 8

P$_{vs}$(Bar)

Figure 9 (Art antérieur)

T$_1$=242°C

n$_r$(mole)

Figure 10

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- JP 9326404 A

- US 3723190 A

**Littérature non-brevet citée dans la description**

- **G.L. Destéfanis.** Electrical Doping Of HgCdTe by Ion Implantation and Heat Treatment. *Journal of Crystal Growth,* 1988, 700-722